# EUROPÄISCHE PATENTSCHRIFT

(11) **EP 1 111 706 B1**
(45) Veröffentlichungstag und Bekanntmachung des Hinweises auf die Patenterteilung: **05.03.2003**
(21) Anmeldenummer: 01102691.1
(22) Anmeldetag: 21.11.1996
(51) Int. Cl.: H01P 1/06

(54) **Vorrichtung zur Signalübertragung zwischen beweglichen Teilen**
Device for transmitting signals between moving parts
Dispositif pour la transmission de signaux entre des éléments mobiles

(30) Priorität: 22.11.1995 DE 19543558; 22.11.1995 DE 19543559; 01.02.1996 DE 19610628
(43) Veröffentlichungstag der Anmeldung: 27.06.2001
(62) Teilanmeldung aus: 96940989.5
(73) Patentinhaber: Schleifring und Apparatebau GmbH, 82256 Fürstenfeldbruck (DE)
(72) Erfinder: Lohr, Georg, Dr., 82223 Eichenau (DE)
(74) Vertreter: Münich, Wilhelm, Dr.

(56) Entgegenhaltungen:
- US-A- 4 613 973
- J. TER HORST ET AL.: "A variable delay circuit for use at high repetitive rates" JOURNAL OF PHYSICS E SCIENTIFIC INSTRUMENTS., Bd. 9, Nr. 4, April 1976 (1976-04), Seiten 310-312, XP002032703 BRISTOL GB
- W. FILENSKY ET AL.: "The GaAs MESFET as a pulse regenerator, amplifier, and laser modulator in the Gbit/s range" IEEE JOURNAL OF SOLID-STATE CIRCUITS, Bd. 12, Nr. 3, Juni 1977 (1977-06), Seiten 276-280, XP002032704 NEW YORK US

## Beschreibung

### Technisches Gebiet

Die Erfindung bezieht sich auf eine Vorrichtung zur Übertragung von hochfrequenten sowie digitalen Signalen zwischen bewegten Teilen, bestehend aus einer Signalquelle und einer Signalsenke verbunden durch einen Übertragungskanal.

### Stand der Technik

Hochfrequente wie auch digitale Signale müssen häufig zwischen relativ zueinander beweglichen Teilen übertragen werden. Ein typisches Einsatzgebiet solcher Übertragungsstrecken liegt in der Radartechnik, wo Signale von der Sende- und Empfangseinheit zur Antenne übertragen werden. Gegenstand der Erfindung ist hier nicht die Hochleistungs-Mikrowellen-Übertragung, sondern die Übertragung hochfrequenter Signale wie z.B. Zwischenfrequenz-Signale oder auch digitale Daten. Derartige Signale werden in der Regel als unsymmetrische Signale zur Verfügung gestellt. Es sind verschiedene Vorrichtungen bekannt, um derartige unsymmetrische Signale zu übertragen.

So kann z.B. die Übertragung kapazitiv mittels eines Plattenpaketes ähnlich einem Drehkondensator erfolgen. Das Hauptproblem dieser Anordnung ist der nicht genau definierte Strompfad zwischen den zueinander beweglichen Teilen. So erfolgt ein Stromfluss zunächst über das Plattenpaket. Der rücklaufende Pfad ist in der Regel die Masse, meist als Schirm oder Gehäuse ausgeführt. Bei sich gegeneinander drehenden Teilen ist es aber besonders schwierig, eine gute, induktivitätsarme Masseverbindung herzustellen. Daher sind auch die bekannten Übertragungssysteme problembehaftet. Es ist hier sehr schwierig, konstante Übertragungseigenschaften und eine konstante Übersprechdämpfung zu erreichen.

Zwar zeichnen sich Übertragungsstrecken mittels Drehkondensatoren durch eine relativ hohe Bandbreite im Gegensatz zu anderen Übertragungstechniken aus, doch liegt der Nachteil im hohen technischen Aufwand der Plattenpakete und einer oberen Grenzfrequenz, die weit unter einer Wellenlänge liegt, die den Abmessungen des Plattenpaketes entspricht. Ein weiterer Nachteil dieser Anordnung ist die hohe Empfindlichkeit gegenüber mechanischen Beanspruchungen sowie Stoß und Vibration.

Auf verkoppelte Resonanzkreise basierende Übertragungsstrecken besitzen gute Übertragungseigenschaften, sind aber naturgemäß nur sehr schmalbandig. Sie sind auch gekennzeichnet durch einen hohen fertigungstechnischen Aufwand und benötigen gegebenenfalls einen Abgleich. Für unterschiedliche Anwendungsfälle müssen diese Elemente jeweils unterschiedlich dimensioniert werden, so dass es kaum möglich ist, mit solchen Übertragungsstrecken in Standardbauform eine breite Produktpalette zu realisieren.

Um die Nachteile dieser Anordnungen zu vermeiden wurden von mehreren Seiten Versuche Unternommen, die Hochfrequenzübertragungseigenschaften konventioneller Schleifringe zu verbessern. Ein solches Verfahren ist die gleichzeitige Einspeisung der Signale an mehreren Stellen, so dass in manchen Betriebszuständen Resonanzen erst bei höheren Frequenzen auftreten.

Ein anderes Verfahren versucht, einen Schleifring mit definiertem Wellenwiderstand auszubilden und diesen an einer geeigneten Stelle mit dem Wellenwiderstand abzuschließen.

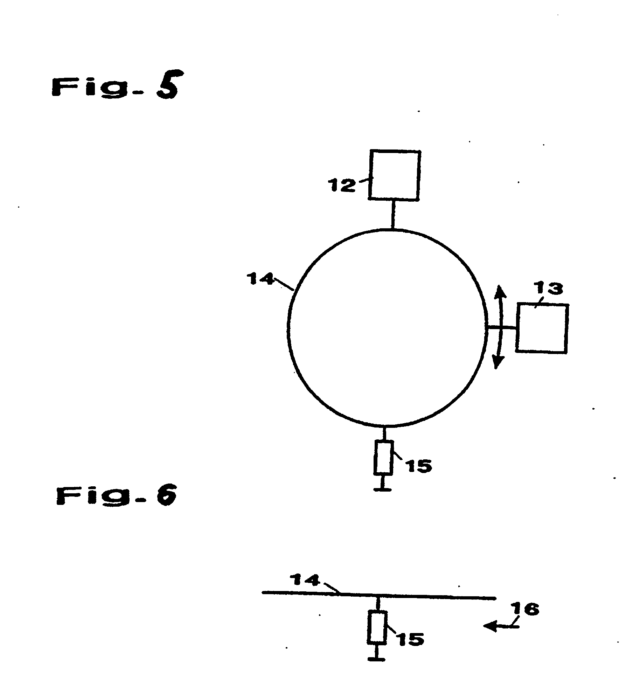

Beide Verfahren sind für eine breitbandige Hochfrequenzübertragung gänzlich ungeeignet, da sie von einer geschlossenen, ringförmigen Kontaktbahn ausgehen. Diese wird immer eine kapazitive Last darstellen. Selbst bei Anbringung eines dem Wellenwiderstand entsprechenden Widerstandes kann ein geschlossener Ring niemals reflexionsfrei gestaltet werden. Warum dies nicht möglich ist, soll anhand von Fig. 5 und Fig. 6 erläutert werden.

Fig. 5 zeigt einen geschlossenen Ring, ausgebildet mit einem Wellenwiderstand von Z₀ = 50 Ω. An diesem ist ein reeller Widerstand 15 mit R = 50 Ω angebracht. In Fig. 6 ist nun ein kleiner Ausschnitt des Ringes mit dem reellen Widerstand dargestellt. Unter der Prämisse, dass der Ring tatsächlich reflexionsfrei abgeschlossen ist, würde eine in Richtung 16 fortschreitende Welle vor dem Widerstand 15 eine Impedanz vorfinden, die sich aus einer Parallelschaltung von dem reellen Widerstand mit R 50 Ω sowie der hinter dem Widerstand weiterführenden Leitung mit Z₀ = 50 Ω ergibt. Der Wert der Parallelschaltung wäre damit 25 Ω. Damit kann für die Welle vor dem Widerstand die Leitung nicht reflexionsfrei sein. Auch mit allen anderen Kombinationen von Wellenwiderständen und Abschlusswiderständen lässt sich hier keine reflexionsfreie Leitung realisieren.

Die vorstehend beschriebenen kontaktlosen Übertragungsverfahren zeichnen sich gegenüber den kontaktierenden Verfahren durch vernachlässigbare mechanische Reibung und damit fehlenden Abrieb bzw. Kontaktverschleiß aus. Die Lebensdauer solcher kontaktloser Übertragungssysteme liegt insbesondere bei hohen Geschwindigkeiten der bewegten Teile zueinander wesentlich über der Lebensdauer kontaktierender Verfahren. Allen diesen Übertragungsverfahren haftet jedoch der Nachteil an, dass sie eine untere Grenzfrequenz besitzen. Diese kann je nach technischer Ausgestaltung variieren. Kennzeichnend ist jedoch, dass ein Gleichanteil mit der Frequenz 0 nicht direkt übertragen werden kann.

Die in der industriellen Praxis auftretenden Digitalsignale wie sie z. B. in modernen Bussystemen verwendet werden, variieren zwischen nahezu statischen Signalen mit äußerst niedrigen Frequenzen und Signalen mit einer durch das Bussystem vorgegebenen maximalen Taktrate. Die niedrigsten vorkommenden Frequenzen liegen meist unter der unteren Grenzfrequenz der zuvor beschriebenen kontaktlosen Überstragungssysteme.

Damit ist eine direkte Übertragung dieser Signale in der Regel nicht möglich. Abhilfe schaffen hier die bekannten Verfahren zur Modulation bzw. Kodierung. Beide Verfahren setzen einen hohen technischen Aufwand voraus. Insbesondere die für die Digitalsignalübertragung gut geeigneten Kodierungsverfahren, wie z. B. die Manchesterkodierung, benötigen alleine aufgrund der Kodierung eine höhere Bandbreite des Übertragungskanals. Dadurch steigen Aufwand und Kosten der Übertragungsstrecke. Außerdem wird bei den meisten Kodierungen der Takt des Digitalsignals benötigt. Häufig ist dieser
Takt aus dem Signal selbst nicht rekonstruierbar. Nur wenn die Daten eine geeignete Struktur besitzen, ist mittels PLLs eine Taktregeneration möglich. Derartige Schaltungen sind meist für eine vorher festgelegte Datenrate einsetzbar. Soll die kontaktlose Übertragungsstrecke daten- und protokolltransparent sein, so lassen sich häufig nur die aufwendigen Modulationsverfahren einsetzen.

### Beschreibung der Erfindung

Der Erfindung liegt die Aufgabe zugrunde, eine Vorrichtung zur Übertragung von Signalen zwischen beweglichen Teilen bestehend aus einer Signalquelle und einer Signalsenke verbunden durch einen Übertragungskanal derart weiterzubilden, daß eine zuverlässige, breitbandige Übertragung gewährleistet ist, ohne daß eine Masseverbindung zwischen den beweglichen Teilen benötigt wird. Insbesondere soll eine Vorrichtungen angegeben werden, die für die Übertragung von digitalen Signalen geeignet ist. Ferner soll zur Übertragung von digitalen Signalen eine protokoll- und datentransparente Übertragung mit einer Datenrate unter der unteren Grenzfrequenz der Übertragungsstrecke mit geringem technischen Aufwand und ohne vergrößertem Bandbreitenbedarf möglich sein.

Eine Vorrichtung gemäß dem Oberbegriff des Anspruchs 1 ist derart ausgebildet, dass die Übertragungsstrecke symmetrisch aufgebaut ist und dadurch ein genau definierter Strompfad vorhanden ist. Hin- und Rückweg des Stromes sind näherungsweise gleich ausgeführt. So muß der Signalstrom nicht über einen anderen, schlecht definierten Weg zurückfließen. Damit spielen schlechte Masseverbindungen keine Rolle mehr, es kann sogar auf eine Masseverbindung vollständig verzichtet werden. Damit kann gleichzeitig eine Potentialtrennung der relativ zueinander beweglichen Teile erreicht werden. Durch die symmetrische Übertragung ergibt sich weiterhin eine ausgezeichnete Gleichtaktunterdrückung. Dies ist gerade in jenen Fällen sehr von Vorteil, in denen eine schlechte oder keine Masseverbindung zwischen den beweglichen Teilen besteht, so daß erhebliche Spannungsdifferenzen zwischen diesen Teilen bestehen können.

Die Lösungen der der Erfindung zugrunde liegenden Aufgabe ist im den Patentanspruch 1 angegeben. Vorteilhafte Weiterbildungen der Erfindung sind Gegenstand der Unteransprüche.

Zur Übertragung digitaler Signale ist erfindungsgemäß eine Vorrichtung nach Anspruch 1 derart ausgebildet, dass der Sender eine Schaltung zur Signalaufbereitung besitzt, welche die Steilheit der Signalflanken des von der Datenquelle gelieferten digitalen Signals derart erhöht, dass die Kehrwerte von Anstiegs- und Abfallzeit jeweils größer als die untere Grenzfrequenz der Übertragungsstrecke sind, und weiterhin im Empfänger eine Auswerteschaltung vorhanden ist, die aus den von der Übertragungsstrecke gelieferten Pulsen, die durch Differentiation der vom Sender abgegebenen Signale entstehen, die ursprünglichen Signale rekonstruiert.

### Kurze Beschreibung der Zeichnungen

Die Erfindung wird nachstehend anhand von Ausführungsbeispielen unter Bezugnahme auf die Zeichnung exemplarisch beschrieben. Es zeigen:
- Fig. 1: Schematisierte Anordnung einer erfindungsgemäßen Übertragungsstrecke nach Anspruch 1,
- Fig. 2: schematisierte Anordnung einer Übertragungstrecke nach dem Stand der Technik,
- Fig. 3: schematisierte Empfängereinheit,
- Fig. 4: Signaldarstellung in einem Zeit-/Amplitudendiagramm,
- Fig. 5: Übertragungseinrichtung gemäß dem Stand der Technik
- Fig. 6: Ausschnitt aus der Darstellung gemäß Figur 5

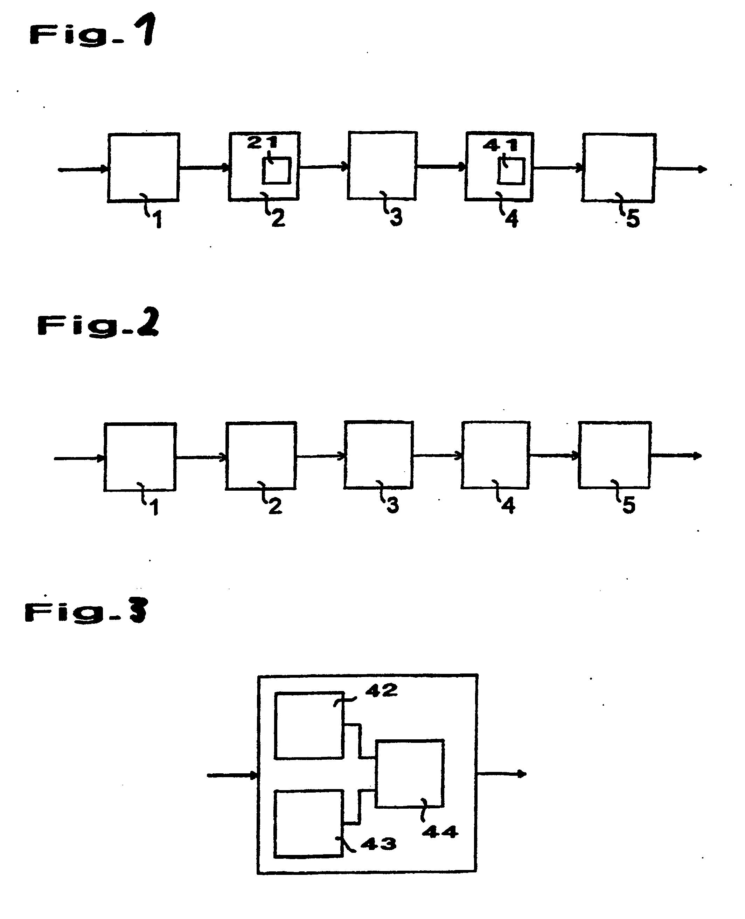

Fig. 1 zeigt eine erfindungsgemäße Anordnung nach Anspruch 1 bestehend aus einer Datenquelle 1 und einer Datensenke 5, welche über den Sender 2, die Übertragungsstrecke 3 und den Empfänger 4 miteinander verbunden sind. Der Sender enthält eine Schaltung zur Signalaufbereitung 21, so daß eine minimale Steilheit der Signalflanken sichergestellt ist. Im Empfänger befindet sich eine Auswerteschaltung 41, die aus dem durch die Übertragungsstrecke verzerrten Signal das Originalsignal rekonstruiert.
Der Sender 2 besitzt eine Schaltung zur Signalaufbereitung 21. Diese erhöht die Flankensteilheit der von der Datenquelle gelieferten Digitalsignale derart, dass die Kehrwerte von Ausstiegs- bzw. Abfallzeit jeweils größer als die untere Grenzfrequenz der Übertragungsstrecke sind. Die so aufbereiteten Signale werden dann vom Sender an die Übertragungsstrecke 3 abgegeben. Durch die Bandpasscharakteristik der Übertragungsstrecke erreichen den Empfänger 4 nur noch einzelne Pulse, die je nach der vom Sender abgegebenen Flanke positive oder negative Werte annehmen. Im Empfänger ist eine Auswerteschaltung 41 vorhanden, die nun aus diesen Pulsen das ursprüngliche Signal wieder rekonstruiert. Das rekonstruierte Signal wird vom Empfänger an die Datensenke übermittelt.
In einer vorteilhaften Ausgestaltung der Erfindung besitzt die Auswerteschaltung einen Integrator, der die von der Übertragungsstrecke kommenden Impulse aufintegriert.
In einer weiteren Ausgestaltung der Erfindung besitzt die Auswerteschaltung einen ersten Komparator zur Detektion negativer Impulse. Ein digitaler Speicher wird durch den ersten Komparator gesetzt und durch den zweiten Komparator zurückgesetzt. Dadurch wird die Polarität des zuletzt aufgetretenen Impulses gespeichert Da die Impulse nur bei Flanken des Signals der Datenquelle auftreten, zeigen sie Änderungen im Signalpegel an. Durch das Speichern dieser Änderungen spiegelt der Ausgang des Speichers den letzten Signalpegel wieder.

Fig. 2 zeigt eine dem Stand der Technik entsprechende Anordnung. Diese besteht aus Datenquelle 1, Sender 2, Übertragungsstrecke 3, Empfänger 4 sowie einer Datensenke 5.

Fig. 3 zeigt eine typische Ausgestaltung der Schaltung zur Signalaufbereitung im Empfänger. Diese enthält einen ersten Komparator 42 zur Detektion positiver Pulse sowie einen zweiten Komparator 43 zur Detektion negativer Pulse. Die Ausgangssignale der beiden Komparatoren werden mittels eines Speicherelementes 44 zusammengeführt.

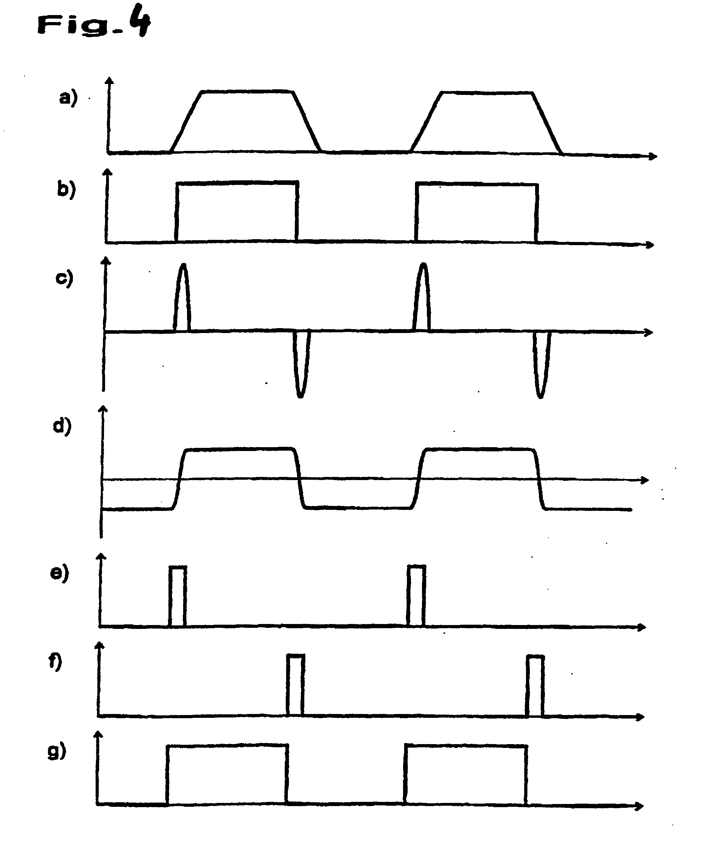

Fig. 4 verdeutlicht die Funktionsweise der erfindungsgemäßen Anordnung nach Anspruch 1. Die Kurve a) zeigt ein typisches Signal, wie es von der Datenquelle zur Verfügung gestellt wird. Dieses Signal wird nun von der Schaltung zur Signalaufbereitung des Senders so aufbereitet, daß eine minimale Steilheit der Signalflanken sichergestellt ist. Dieses Signal zeigt die Kurve b). Nach der Übertragungsstrecke mit Bandpaßcharakteristik besitzt das Signal die Kurvenform c). Aus diesem Signal muß nun der Empfänger mit Hilfe einer Auswerteschaltung das Originalsignal rekonstruieren. Wird das Signal nun entsprechend einer Ausgestaltung der Erfindung mittels eines Integrators aufintegriert, so ergibt sich die in Kurve d) dargestellte Signalform. In einer anderen Ausgestaltung der Erfindung wird die Auswertung mittels zweier Komparatoren und eines Speichers vorgenommen. Die Kurve e) zeigt das Ausgangssignal des ersten Komparators zur Detektion positiver Pulse. Die Kurve f) zeigt das Ausgangssignal des zweiten Komparators zur Detektion negativer Pulse. Das Ausgangssignal des Speichers ist in Kurve g) dargestellt.

Fig. 5 zeigt einen geschlossenen Ring, ausgebildet mit einem Wellenwiderstand von Z₀ = 50 Ω. An diesem ist ein reeller Widerstand 15 mit R = 50 Ω angebracht.
In Fig. 6 ist nun ein kleiner Ausschnitt des Ringes mit dem reellen Widerstand dargestellt. Unter der Prämisse, dass der Ring tatsächlich reflexionsfrei abgeschlossen ist, würde eine in Richtung 16 fortschreitende Welle vor dem Widerstand 15 eine Impedanz vorfinden, die sich aus einer Parallelschaltung von dem reellen Widerstand mit R = 50 Ω sowie der hinter dem Widerstand weiterführenden Leitung mit Z₀ = 50 Ω ergibt. Der Wert der Parallelschaltung wäre damit 25 Ω. Damit kann für die Welle vor dem Widerstand die Leitung nicht reflexionsfrei sein. Auch mit allen anderen Kombinationen von Wellenwiderständen und Abschlusswiderständen lässt sich hier keine reflexionsfreie Leitung realisieren.

## Patentansprüche

1. Vorrichtung zur kontaktlosen Übertragung von Signalen zwischen bewegten Teilen, bestehend aus einer Datenquelle zur Erzeugung der Signale, einem Sender, der diese Signale mittels einer kontaktlosen Übertragungsstrecke mit Bandpaßcharakteristik an den Empfänger übermittelt, und einer Datensenke, die die Daten aus dem Empfänger aufnimmt,
**dadurch gekennzeichnet, daß** der Sender eine Schaltung zur Signalaufbereitung besitzt, welche die Steilheit der Signalflanken des von der Datenquelle gelieferten Signals derart erhöht, daß die Kehrwerte von Anstiegs- und Abfallzeit jeweils größer als die untere Grenzfrequenz der Übertragungsstrecke sind, und weiterhin im Empfänger eine Auswerteschaltung vorhanden ist, die aus den von der Übertragungsstrecke gelieferten Pulsen, die durch Differentiation der vom Sender abgegebenen Signale entstehen, die ursprünglichen Signale rekonstruiert.

2. Vorrichtung nach Anspruch 1,
**dadurch gekennzeichnet, daß** die Auswerteschaltung einen Integrator besitzt, der die von der Übertragungsstrecke kommenden Pulse aufintegriert und das integrierte Signal an die Datensenke weiterleitet.

3. Vorrichtung nach Anspruch 1 oder 2,
**dadurch gekennzeichnet, daß** in der Auswerteschaltung ein erster Komparator zur Detektion positiver Pulse und ein zweiter Komparator zur Detektion negativer Pulse sowie ein Speicherelement vorgesehen ist, welches mit beiden Komparatoren verbunden ist und mittels der Ausgangssignale der Komparatoren die Polarität des zuletzt aufgetretenen Impulses speichert und ein dem Speicherzustand entsprechendes Signal an die Datensenke übergibt.

4. Vorrichtung nach einem der Ansprüche 1 bis 3,
**dadurch gekennzeichnet, daß** die zu übertragenen Signale digitale Signale sind.

## Claims

1. Device for non-contacting transmission of signals between moved parts, consisting of a data source for generating the signals, of an emitter that communicates these signals to the receiver by means of a non-contacting transmission path with band-pass characteristic, and of a data sink collecting the data from said receiver,
**characterised in that** said emitter comprises a circuit for signal processing, which increases the steepness of the signal flanks of the signal provided by said data source, in such a way that the reciprocal values of the rise time and the fall time each exceed the lower limit frequency of the transmission path, and that moreover an analyser circuit is provided in said receiver, which reconstructs the original signals from the pulses supplied by said transmission path, which are created by differentiation of the signals emitted by said emitter.

2. Device according to Claim 1,
**characterised in that** said analyser circuit comprises an integrator that adds the pulses by integration, which arrive from said transmission path, and that passes the integrated signal to said data sink.

3. Device according to Claim 1 or 2,
**characterised in that** in said analyser circuit a first comparator is provided for the detection of positive pulses, and a second comparator for the detection of negative pulses as well as a memory element are provided, which memory element is connected to both comparators, stores the polarity of the pulse that occurred last and transfers a signal corresponding to the stored state to said data sink.

4. Device according to any of the Claims 1 to 3,
**characterised in that** the signals to be transmitted are digital signals.

## Revendications

1. Dispositif de transmission sans contact de signaux entre des composants mobiles, composé d'une source de données afin d'engendrer des signaux, d'un émetteur, qui transmet ces signaux au récepteur par une voie de transmission sans contact à caractéristique de passe-bande, et d'une source négative de données, qui reçoit les données dudit récepteur,
**caractérisé en ce que** ledit émetteur comprend un circuit de traitement de signaux, qui augmente la pente des flancs du signal fourni par ladite source de données, d'une façon, que chacune des valeurs réciproques du temps de montée et du temps de décroissance dépasse la fréquence de limite inférieure de la voie de transmission, et **en ce que** de plus un circuit d'analyse est formé dans ledit récepteur, qui reconstruit les signaux originaux en les dérivant des impulsions fournies par ladite voie de transmission, qui sont engendrées par différentiation des signaux émis par ledit émetteur.

2. Dispositif selon la revendication 1,
**caractérisé en ce que** dans ledit circuit d'analyse comprend un intégrateur, qui additionne les impulsions par intégration, qui arrivent de ladite voie de transmission, et qui passe le signal intégré vers ladite source négative de données.

3. Dispositif selon la revendication 1 ou 2,
**caractérisé en ce que** dans ledit circuit d'analyse un premier comparateur est prévu pour la détection des impulsions positives, ainsi qu'un deuxième comparateur à détecter des impulsions négatives, ainsi qu'un élément de mémoire, qui est relié auxdits deux comparateurs, qui mémorise la polarité de l'impulsions, qui apparaissait en dernier, et que transfère un signal correspondant à l'état de mémorisation à ladite source négative de données.

4. Dispositif selon une quelconque des revendications 1 à 3,
**caractérisé en ce que** les signaux à transmettre sont des signaux numériques.
